# EUROPÄISCHE PATENTSCHRIFT

(11) **EP 0 631 322 B1**
(45) Veröffentlichungstag und Bekanntmachung des Hinweises auf die Patenterteilung: **30.07.1997**
(21) Anmeldenummer: 94107005.4
(22) Anmeldetag: 04.05.1994
(51) Int. Cl.: H01L 29/15, H01L 21/3115, H01L 21/335

(54) **Mikroelektronische Schaltungsstruktur und Verfahren zu deren Herstellung**
Microelectronic circuit struture and its manufacturing method
Structure de circuit microélectronique et son procédé de fabrication

(30) Priorität: 19.05.1993 DE 4316855
(43) Veröffentlichungstag der Anmeldung: 28.12.1994
(73) Patentinhaber: SIEMENS AKTIENGESELLSCHAFT, 80333 München (DE)
(72) Erfinder: Hofmann, Karl R., Dr, D-30974 Wennigsen (DE); Schulz, Maximilian, Prof.Dr., D-8525 Weiher (DE)

(56) Entgegenhaltungen:
- EP-A- 0 213 972
- EP-A- 0 308 814
- US-A- 5 047 649
- IEEE TRANSACTIONS ON ELECTRON DEVICES, Bd.39, Nr.6, Juni 1992 Seiten 1469 - 1476, XP271792 J.R. PFIESTER ET AL.
- PHYSICAL REVIEW LETTERS, Bd.63, Nr.15, 9. Oktober 1989 Seiten 1641 - 1644, XP253571 J.S. WEINER ET AL.
- JOURNAL OF VACUUM SCIENCE & TECHNOLOGY B, Bd.8, Nr.4, Juli 1990 Seiten 625 - 629, XP358579 C. SIKORSKI

## Beschreibung

Mikroelektronische Bauelemente und Schaltungen werden in der Halbleitertechnologie in lateraler Richtung durch Isolationsstrukturen und/oder Potentialbarrieren definiert. Die Möglichkeiten zur Miniaturisierung dieser Bauelemente und Schaltungen ist daher mit der erzielbaren Feinheit in den zur Herstellung von Isolationsstrukturen und Potentialbarrieren verwendeten Strukturierungsverfahren verknüpft.

Dieses gilt sowohl für konventionelle Bauelemente wie z. B. MOSFETs oder MODFETs als auch für neuartige Bauelementkonzepte der Nanoelektronik. In diesen Bauelementen der Nanoelektronik werden bei Dimensionen um 10 nm quantenmechanische Effekte ausgenutzt (s. z. B. K.K. Likharev et al, Spektrum der Wissenschaft, August 1992, Seite 62 bis 67 und E. Corcoran, Spektrum der Wissenschaft, Januar 1991, S. 76 - 86). Durch laterale Strukturierung werden in Halbleitersubstraten leitende Grenzflächen- oder Quanten-Well-Kanäle erzeugt, in denen sich zweidimensionale Elektronen- oder Lochergase ausbilden. Diese sind in vertikaler Richtung quantisiert. Bei weiterer Verkleinerung der Dimensionen kommt eine laterale Quantisierung dazu, wodurch Quantendraht- oder Quantendotstrukturen entstehen. In der Nanoelektronik wird darüberhinaus das quantenmechanische Tunneln durch dünne, laterale Potentialbarrieren, die zwischen benachbarten Strukturen angeordnet sind, ausgenutzt.

Zur lateralen Strukturierung von Halbleitern ist es bekannt, Lithographieverfahren in Verbindung mit entsprechenden Strukturübertragungsverfahren einzusetzen. Die wesentlichen Strukturübertragungsverfahren sind die Schichtabscheidung, Ätzverfahren und Dotierungsverfahren. Zur Erzeugung von Strukturen mit lateralen Abmessungen unter 0,1 µm werden vorwiegend Röntgen-, Elektronen- und Ionenstrahllithograpie verwendet. Mit Elektronenstrahllithographie können Strukturen bis zu 30 nm hergestellt werden. Die Eignung von Lithographie, Abscheidungs- und Oberflächenmodifikationsverfahren unter Verwendung von Scanning-Tunneling-Mikroskopen und Atomic-Phos-Mikroskopen zur Erzielung noch kleinerer Strukturen ist Gegenstand von Untersuchungen (s. z. B. M.A. McCord et al, J. Vac. Sci. Techn. B4 (1) S. 86 - 88 (1986) oder G. Binnig et al, Phys. Rev. Lett. 56, S. 930 f (1986)).

Neben dem Auflösungsvermögen der verwendeten Lithographie wird die Strukturfeinheit von durch Dotierung erzeugten Gebieten im Halbleiter dadurch begrenzt, daß Implantationsgebiete im Halbleiter bei der erforderlichen Aktivierung durch Ausheilung auseinanderlaufen.

Die Schrift IEEE Transactions on Electron Devices, 39 (1992), no. 6 Seiten 1469 - 1476, J.R. Pfiester et al. betrifft einen LDD NMOS-Transistor, bei dem zur Verbesserung des Problems der heißen Ladungsträger seitlich der Gatelektrode in einer Oxidschicht Cäsiumatome vorgesehen sind. Diese werden durch Implantation eingebracht und wirken als positive Ladungsträger, die die n⁻-Elektron-Oberflächenkonzentration in den LDD-Gebieten erhöhen. Die Gateelektrode überlappt die LDD-Gebiete nicht, so daß zusätzliche Gateüberlappkapazitäten vermieden werden (siehe Seite 1469 linke Spalte, Ende des zweiten Absatzes). Zur Herstellung des Transistors werden zunächst die Gateelektroden strukturiert, anschließend werden die LDD-Gebiete implantiert. Danach erfolgt die Cäsiumimplantation in einer SiO₂-Schicht an der Oberfläche. Das Cäsium wird herstellungsgemäß nur außerhalb der Gateelektrode eingebracht.

Aus der Schrift Physical Review Letters, 63 (1989), no. 15, Seiten 1641-1644, J.S. Weiner et al. ist eine Untersuchung eines Elektronengases in einer Halbleiterstruktur bekannt, die eine Vielzahl von Quantendrähten aufweist. Die Quantendrähte werden in einer GaAs/AlGaAs-Heterostruktur durch eine deltadotierte Schicht mit eingelagerten Siliziumatomen realisiert. Diese deltadotierte Schicht verbiegt die Bandstruktur im Kristall.

Aus der Schrift Journal of Vacuum Science of Technology B, 8 (1990), no. 4, Seiten 625-629, Ch. Sikorski ist die Bildung von Quantendrähten und Quantenpunkten in InSb unter Ausnutzung des Schottky-Effektes bekannt. Dazu wird auf die Oberfläche eines InSb-Kristalls ein Metallgitter aus NiCr aufgebracht, das in direktem Kontakt mit dem Halbleiter eine Schottky-Diode bildet. Im Bereich der Schottky-Dioden wird die Bandstruktur im Halbleiter so verändert, daß zwischen benachbarten Gitterelementen jeweils ein Potentialminimum auftritt. Das Metallgitter ist mit einer SiO₂-Schicht bedeckt, oberhalb der eine Gateelektrode angeordnet ist.

Der Erfindung liegt das Problem zugrunde, eine mikroelektronische Schaltungsstruktur anzugeben, die mit Strukturfeinheiten im Bereich 10 nm herstellbar ist. Des weiteren soll ein Verfahren zu deren Herstellung angegeben werden.

Dieses Problem wird erfindungsgemäß gelost durch eine mikroelektronische Schaltungsstruktur nach Anspruch 1 und ein Verfahren nach Anspruch 16. Weitere Ausgestaltungen der Erfindung gehen aus den Unteransprüchen hervor.

Die erfindungsgemäße Schaltungsstruktur umfaßt mindestens eine Halbleiterschicht und eine dielektrische Schicht, die einander benachbart angeordnet sind. Die dielektrische Schicht weist nahe der Grenzfläche zur Halbleiterschicht eine elektrische Ladungsverteilung auf, die in der Halbleiterschicht eine Verschiebung des lokalen Halbleiteroberflächenpotentials bewirkt. Die Ladungsverteilung wird z. B. durch feste positive und/oder negative elektrische Ladungen in der dielektrischen Schicht erzeugt. Form und Ausdehnung des Gebietes in der Halbleiterschicht, in dem die Verschiebung des lokalen Halbleiteroberflächenpotentials durch das elektrische Feld der Ladungsverteilung bewirkt wird, wird durch die Ladungsverteilung in der dielektrischen Schicht vorgegeben. Auf diese Weise können zweidimensionale Grenzflächenkanäle und lokale Potentialbarrieren an der Oberfläche der Halbleiterschicht erzeugt werden. In der erfindungsgemäßen mikroelektronischen Schaltungsstruktur wird der Potentialverlauf in der Halbleiterschicht durch die elektrische Ladungsverteilung in der dielektrischen Schicht eingestellt. Im Gegensatz dazu wird der Potentialverlauf in Halbleiterschichten herkömmlicher Bauelemente durch eine Ladungsverteilung in der Halbleiterschicht selbst, die Dotierung, eingestellt.

Es liegt im Rahmen der Erfindung, auf der Oberfläche der dielektrischen Schicht eine Gateelektrode anzuordnen, über die die Verschiebung des lokalen Halbleiteroberflächenpotentials in der Halbleiterschicht steuerbar ist.

Die laterale Struktur von durch die Ladungsverteilung bewirkten Grenzflächenkanälen und Potentialbarrieren an der Oberfläche oder der Halbleiterschicht hängt von der Dimension der dielektrischen Schicht sowie von der Lage, Ausdehnung und Größe der Ladungen, die die elektrische Ladungsverteilung bilden, ab. Ferner wird die Struktur beeinflußt von der Anwesenheit einer Gateelektrode sowie der an die Gateelektrode angelegten Spannung. Schließlich ist die Struktur abhängig von der Dotierung, Substratvorspannung und Materialstruktur der Halbleiterschicht.

Die erfindungsgemäße mikroelektronische Schaltungsstruktur kann sowohl als konventionelles Bauelement, z. B. MOSFET, als auch als Bauelement im Sinne der Nanoelektronik ausgebildet sein. Insbesondere kann die erfindungsgemäße Schaltungsstruktur auf Quanten-Well-Kanalstrukturen angewendet werden.

Es ist besonders vorteilhaft, größere Schaltungsstrukturen, die aus mehreren miteinander über Leiterbahnen verschalteten Schaltelementen zusammengesetzt sind, als erfindungsgemäße Schaltungsstruktur auszubilden. In diesem Fall werden die die einzelnen Schaltelemente verbindenden Leiterbahnen ebenfalls durch einen entsprechenden Verlauf der elektrischen Ladungsverteilung in der dielektrischen Schicht erzeugt.

Die Halbleiterschicht in der erfindungsgemäßen Schaltungsstruktur besteht insbesondere aus monokristallinem Silizium oder einem III-V-Halbleiter. Die Halbleiterschicht kann dabei Teil eines Halbleitersubstrats sein. Es ist besonders vorteilhaft, als Halbleiterschicht die Siliziumschicht eines SOI-Substrates zu verwenden. In diesem Fall lassen sich benachbarte Schaltungsstrukturen leicht von einander isolieren.

Die Ladungsverteilung in der dielektrischen Schicht wird erfindungsgemäß durch in der dielektrischen Schicht lokalisiert angeordnete Ladungen erzeugt. Als Ladungen sind z. B. positiv geladene Metallionen wie z. B. Kalium, Cäsium und Rubidium geeignet. Ferner ist es möglich, an der Grenzfläche befindliche Ladungsträgertraps durch Ladungsträgerinjektion zu beladen. Als Trap sind z. B. in SiO₂ implantierte Wolframionen geeignet, die lokalisiert gezielt mit Elektronen beladen werden. Ferner liegt es im Rahmen der Erfindung, die dielektrische Schicht aus drei Schichten aufzubauen, wobei die mittlere Schicht einen höheren Einfangquerschnitt für Ladungsträger aufweist als die beiden äußeren Schichten. Die beiden äußeren Schichten bilden eine Potentialbarriere gegen Ladungsträgerabfluß aus der mittleren Schicht. Die Dicke der der Halbleiterschicht benachbarten äußeren Schicht wird dabei so eingestellt, daß die Ladungsverteilung von in der mittleren Schicht eingefangenen Ladungsträgern die Verschiebung des lokalen Halbleiteroberflächenpotentials in der Halbleiterschicht bewirkt. Die beiden äußeren Schichten werden z. B. aus SiO₂ gebildet, während die mittlere Schicht aus Si₃N₄ oder Al₂O₃ gebildet wird.

Es liegt ferner im Rahmen der Erfindung, daß die dielektrische Schicht eine ferroelektrische Schicht umfaßt. Durch lokale Polarisation der ferroelektrischen Schicht kommt es am Rand der ferroelektrischen Schicht zur Ansammlung von Polarisationsladungen. Diese bewirken ein elektrisches Feld, das eine Verschiebung des lokalen Halbleiteroberflächenpotentials in der Halbleiterschicht zur Folge hat.

Zur Herstellung der mikroelektronischen Schaltungsstruktur liegt es im Rahmen der Erfindung, Ladungsträger durch Anlegen eines lokalen elektrischen Feldes in die dielektrische Schicht einzutreiben. Zur Herstellung von Schaltungsstrukturen mit Abmessungen unter 100 nm ist es vorteilhaft, das elektrische Feld dadurch zu erzeugen, daß eine Metallspitze auf die Oberfläche der dielektrischen Schicht an einem Ort, an dem Ladungsträger eingetrieben werden sollen, gerichtet wird und daß zwischen die Metallspitze und die Halbleiterschicht eine elektrische Spannung angelegt wird. Zur Erzielung feinster Strukturen ist als Metallspitze insbesondere die Spitze eines Atomic Force oder Scanning Tunneling Mikroskops geeignet. Diese Spitzen können Felder oberhalb 10⁶ V/cm mit lateralen Abmessungen im Bereich 10 nm erzeugen. Durch Piezomanipulatoren sind sie auf einen Nanometer genau positionierbar.

Es ist vorteilhaft, die Ladungsträger bei einer höheren Temperatur einzutreiben, als der Temperatur, bei der die Schaltungsstruktur betrieben werden soll. Dadurch ist die Beweglichkeit der einzutreibenden Ladungsträger erhöht und es werden zum Eintreiben geringere elektrische Felder benötigt. Umfaßt die dielektrische Schicht eine ferroelektrische Schicht, so liegt es im Rahmen der Erfindung, die lokale Polarisierung der ferroelektrischen Schicht ebenfalls mit Hilfe einer Metallspitze, insbesondere eines Atomic-Force oder Scanning Tunneling Mikroskop durchzuführen.

Im folgenden wird die Erfindung anhand von Ausführungsbeispielen und der Figuren näher erläutert.
- Fig. 1: zeigt eine Schaltungsstruktur mit einer dielektrischen Schicht und einer Halbleiterschicht, wobei in der dielektrischen Schicht Ladungen so angeordnet sind, daß in der Halbleiterschicht ein lokaler Elektronenkanal erzeugt wird.
- Fig. 2: zeigt den Potentialverlauf der in Fig. 1 dargestellten Schaltungsstruktur.
- Fig. 3: zeigt eine Schaltungsstruktur mit einer dielektrischen Schicht und einer Halbleiterschicht, in der durch in der dielektrischen Schicht angeordnete Ladungen in der Halbleiterschicht eine Verarmungszone erzeugt wird.
- Fig. 4: zeigt den Potentialverlauf der in Fig. 3 dargestellten Schaltungsstruktur.
- Fig. 5: zeigt eine Schaltungsstruktur mit einer dielektrischen Schicht und einer Halbleiterschicht, wobei in der dielektrischen Schicht lokalisierte negative und positive Ladungen in der Halbleiterschicht einen Elektronenkanal bzw. eine Löcherbarriere erzeugen.
- Fig. 6: zeigt den Potentialverlauf der Schaltungsstruktur, die in Fig. 5 dargestellt ist.
- Fig. 10 bis Fig. 12: zeigt die Herstellung einer inhomogenen Ladungsverteilung in einer dielektrischen Schicht.
- Fig. 13 bis Fig. 15: zeigt das negative Beladen von Traps in einer dielektrischen Schicht, die aus drei Schichten zusammengesetzt ist.
- Fig. 16 bis Fig. 18: zeigt die Polarisation einer ferroelektrischen Schicht zur Erzeugung der Ladungsverteilung in einer dielektrischen Schicht.

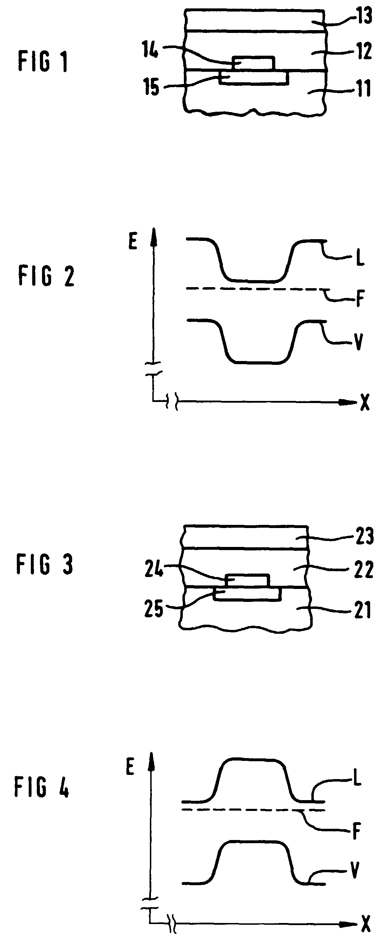

An der Oberfläche einer Halbleiterschicht 11 aus z. B. monokristallinem Silizium ist eine dielektrische Schicht 12 aus z. B. SiO₂ angeordnet (s. Fig. 1). Auf der dielektrischen Schicht 12 ist eine Gateelektrode 13 aus z. B. dotiertem Polysilizium angeordnet. Die Halbleiterschicht 11 ist z. B. p-dotiert. Die dielektrische Schicht weist eine Dicke von z. B. 10 nm auf. In der dielektrischen Schicht 12 sind positive Ladungsträger 14 nahe der Grenzfläche zur Halbleiterschicht 11 angeordnet. Die positiven Ladungsträger 14 sind in einem Abstand von z. B. 2 nm von der Grenzfläche zur Halbleiterschicht 11 angeordnet. Die Verteilung der positiven Ladungsträger 14 weist eine Breite parallel zur Grenzfläche zur Halbleiterschicht 11 von z. B. 10 nm auf. In der Verteilung der positiven Ladungsträger 14 wird eine Dichte von zum Beispiel 10 µC/cm² erreicht. Das elektrische Feld der Verteilung der positiven Ladungsträger 14 bewirkt eine Verschiebung des Oberflächenpotentials in der angrenzenden Oberfläche der Halbleiterschicht. Dadurch kommt es an die Verteilung der positiven Ladungsträger 14 angrenzend zur Ausbildung eines lokalen Elektronenkanals 15 in der Halbleiterschicht 11. In Fig. 2 ist der Potentialverlauf in der in Fig. 1 dargestellten Schaltungsstruktur gezeigt. Mit L wird das Leitungsband, mit F das Ferminiveau und V das Valenzband bezeichnet.

An der Oberfläche einer Halbleiterschicht 21, die z. B. aus p-dotiertem monokristallinem Silizium besteht, ist eine dielektrische Schicht 22 aus z. B. SiO₂ angeordnet (s. Fig. 3). An der Oberfläche der dielektrischen Schicht 22 ist eine Gateelektrode 23 aus z. B. dotiertem Polysilizium angeordnet. In der dielektrischen Schicht 22 sind negative Ladungsträger 24 angeordnet. Die negativen Ladungsträger 24 sind nahe der Grenzfläche zur Halbleiterschicht 21 angeordnet. Die Verteilung der negativen Ladungsträger 24 weist senkrecht zur Oberfläche der Halbleiterschicht 21 eine Ausdehnung von z. B. 2 nm auf. Parallel zur Oberfläche der Halbleiterschicht 21 weist die Verteilung der negativen Ladungsträger 24 eine Ausdehnung von etwa 10 nm auf. Die Dichte der negativen Ladungsträger beträgt zum Beispiel 10 µC/cm². Das elektrische Feld der Verteilung der negativen Ladungsträger 24 bewirkt in der Oberfläche der Halbleiterschicht 21 eine Verschiebung des Oberflächenhalbleiterpotentials. Diese Verschiebung des Oberflächenhalbleiterpotentials führt zu einer Verarmungszone 25 in der Halbleiterschicht.

In Fig. 4 sind Leitungsband L, Ferminiveau F und Valenzband V der in Fig. 3 gezeigten Schaltungsstruktur dargestellt.

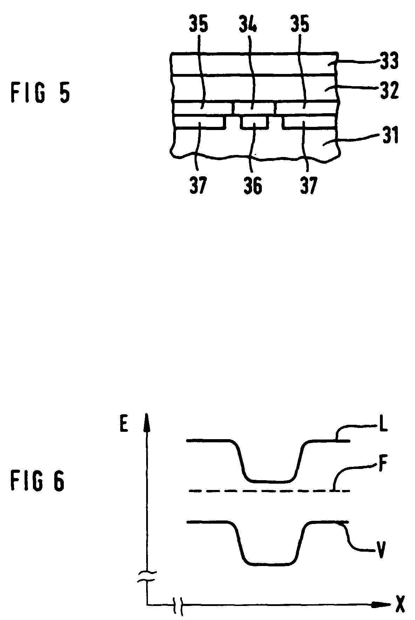

Fig. 5 zeigt wie an der Oberfläche einer Halbleiterschicht 31 aus z. B. p-dotiertem monokristalinem Silizium eine dielektrische Schicht 32 aus z. B. SiO₂ angeordnet ist. Die dielektrische Schicht 32 weist eine Dicke von z. B. 10 nm auf. An der Oberfläche der dielektrischen Schicht 32 ist eine Gateelektrode 33 aus z. B. dotiertem Polysilizium angeordnet. In der dielektrischen Schicht 32 sind in einem ersten Bereich 34 positive Ladungsträger angeordnet. In einem zweiten Bereich 35 sind negative Ladungsträger angeordnet. Die negativen Ladungsträger und die positiven Ladungsträger sind jeweils in einem Abstand von z. B. 2 nm von der Oberfläche der Halbleiterschicht 31 entfernt angeordnet. Parallel zur Oberfläche der Halbleiterschicht 31 weist der erste Bereich 34 eine Breite von z. B. 10 nm auf. Der zweite Bereich 35 grenzt an gegenüberliegenden Seiten an den ersten Bereich 34 an. Im ersten Bereich 34 beträgt die Ladungsträgerdichte 10 µC/cm², in den zweiten Bereichen 35 ebenfalls 10 µC/cm². Das elektrische Feld der negativen und positiven Ladungsträger bewirkt in der Halbleiterschicht 31 die Ausbildung eines Elektronenkanals 36, der dem ersten Bereich 34 benachbart ist. Seitlich des Elektronenkanals 36 bewirkt das elektrische Feld der positiven und negativen Ladungsträger die Ausbildung von Löcherkanälen 37. Der Elektronenkanal 36 stellt gleichzeitig eine Potentialbarriere für Löcher dar.

In Fig. 6 sind Leitungsband L, Ferminiveau F und Valenzband V der in Fig. 5 gezeigten Schaltungsstruktur dargestellt.

In Anwendungsfällen, in denen eine Steuerung der Verschiebung des Halbleiteroberflächenpotentials in der Halbleiterschicht mit Hilfe der Gateelektrode nicht erforderlich ist, kann in denen anhand von Fig. 1, 3 und 5 erläuterten Schaltungsstrukturen die Gateelektrode entfallen.

Durch Umkehrung der Vorzeichen der Ladungsträger in den anhand von Fig. 1 bis 6 erläuterten Ausführungsformen werden aus Elektronenkanälen Löcherkanäle und aus Elektronenbarrieren Löcherbarrieren bzw. umgekehrt.

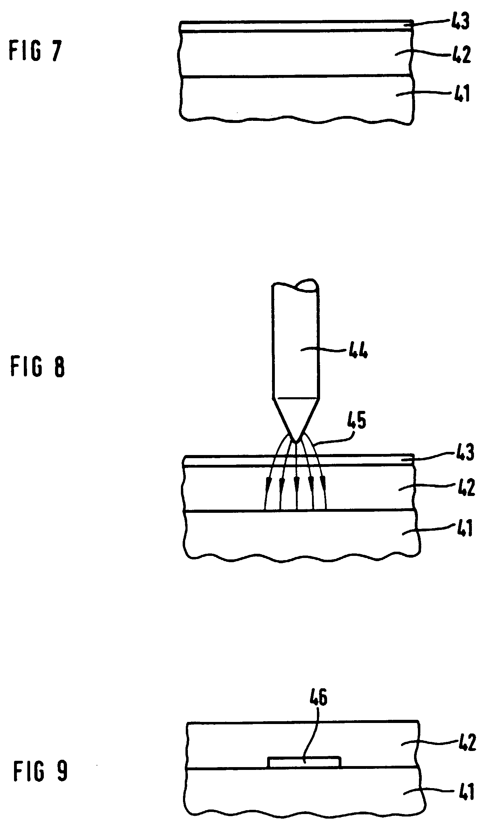

Zur Herstellung einer erfindungsgemäßen Schaltungsstruktur wird auf eine Halbleiterschicht 41 aus z. B. monokristallinem Silizium eine dielektrische Schicht 42 aus z. B. SiO₂ aufgebracht (s. Fig. 7). Die dielektrische Schicht 42 weist eine Dicke von z. B. 10 nm auf. Auf die Oberfläche der dielektrischen Schicht 42 wird eine Metallionen enthaltende Substanz 43 aufgebracht. Als Metallionen wird z. B. Kalium, Rubidium oder Cäsium verwendet. Als Substanz eignen sich z. B. Alkalisalze (zum Beispiel Halogenide).

Auf die Oberfläche der mit der Substanz 43 belegten dielektrischen Schicht 42 wird eine Spitze 44 eines Atomic-Force oder Scanning Tunneling Mikroskops gerichtet (s. Fig. 8). Die Spitze 44 wird mit einer positiven Spannung verbunden. Die Halbleiterschicht 41 wird mit Erdpotential verbunden. Die Spitze 44 wird in einen Abstand von etwa 0 - 10 nm zur Oberfläche der dielektrischen Schicht 42 gebracht. Durch Anlegen einer positiven Spannung von 1 bis 50 Volt an die Spitze 44 wird ein elektrisches Feld 45 erzeugt, das eine Ionendrift der Metallionen in Richtung auf die Grenzfläche von dielektrischer Schicht 42 und Halbleiterschicht 41 bewirkt. Vorzugsweise findet die Ionendrift bei erhöhter Temperatur, z. B. bei 400 Kelvin statt. Bei einigen 100 Kelvin oberhalb Raumtemperatur weisen Kalium, Rubidium und Cäsium eine um Größenordnungen höhere Beweglichkeit auf. Bei Zimmertemperatur bewegen sich diese Metallionen im SiO₂ nicht mehr. Das elektrische Feld 45 bewirkt eine Ansammlung positiver Metallionen 46 in der Nahe der Grenzfläche zur Halbleiterschicht 41. Die Ansammlung positiver Metallionen 46 weist eine Flächendichte von z. B. 10¹³ cm⁻² auf. Die an der Oberfläche der dielektrischen Schicht 42 verbliebene Substanz 43 wird entfernt (s. Fig. 9). Die Verteilung der positiven Metallionen 46 ändert sich bei Raumtemperatur nicht mehr, da hier die Beweglichkeit der Metallionen stark reduziert ist.

Alternativ kann die Substanz 43 durch lokale Abscheidung des Dotierungsmetalls oder durch Ionenimplantation mit oder ohne Lithographie in die Oberfläche der dielektrischen Schicht erzeugt werden.

Zur Fertigstellung der Schaltungsstruktur wird, wenn erforderlich auf die Oberfläche der dielektrischen Schicht 42 eine Gateelektrode aufgebracht.

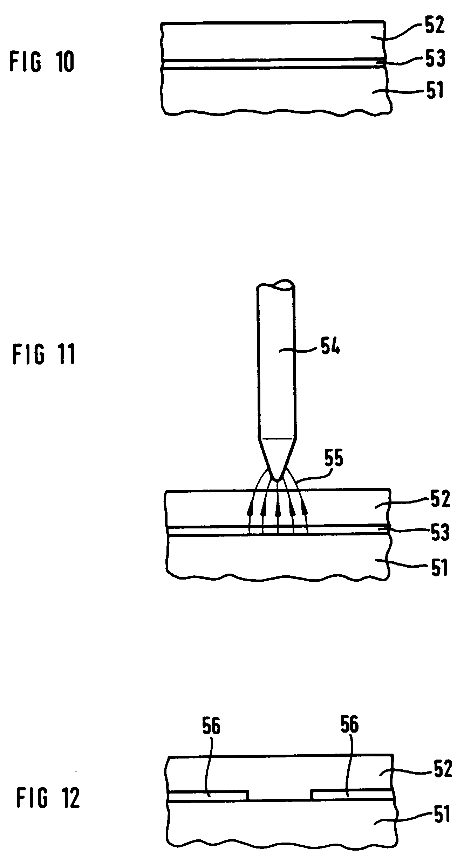

Zur Herstellung komplementärer Schaltungsstrukturen wird auf eine Halbleiterschicht 51 eine dielektrische Schicht 52 aufgebracht, die an der Grenzfläche zur Halbleiterschicht 51 eine Schicht mit positiv geladenen Ladungsträgern 53 aufweist. Die Halbleiterschicht 51 besteht z. B. aus p-dotiertem, monokristallinem Silizium. Die dielektrische Schicht besteht z. B. aus SiO₂ und weist eine Dicke von z. B. 10 nm auf. Die mit positiven Ladungsträgern dotierte Schicht 53 wird z. B. durch ganzflächige Ionenimplantation mit positiv geladenen Ionen oder durch ganzflächige Belegung mit Metallionen und anschließendes ganzflächiges Eintreiben im elektrischen Feld hergestellt (s. Fig. 10).

Auf die Oberfläche der dielektrischen Schicht 52 wird eine Spitze 54 eines Atomic Force oder Scanning Tunneling Mikroskops gerichtet. Die Spitze 54 wird mit Erdpotential verbunden. Die Halbleiterschicht 51 wird mit einer positiven Spannung von z. B. 1 - 50 Volt verbunden (s. Fig. 11). Dadurch bildet sich ein elektrisches Feld 55 aus, in dem eine Ionendrift der positiven Ladungsträger aus der Schicht 53 zur Oberfläche der dielektrischen Schicht 52 hin erfolgt. Die positiven Ladungsträger werden auf diese Weise von der Grenzfläche zur Halbleiterschicht 51 entfernt. Nach Entfernen der dielektrischen Schicht 52 gedrifteten positiven Ladungsträger z. B. durch Abätzen oder Lösungsmittel sind in der dielektrischen Schicht 52 an der Grenzfläche zur Halbleiterschicht 51 nur noch außerhalb des durch die Spitze 54 bewirkten elektrischen Feldes positive Ladungsträger vorhanden.

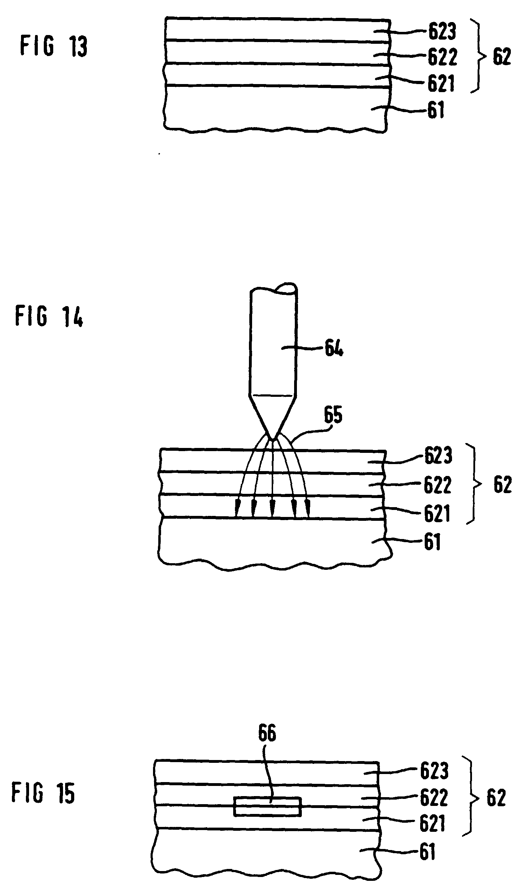

Auf die Oberfläche einer Halbleiterschicht 61 aus z. B. monokristallinem Silizium wird eine dielektrische Schicht 62 aufgebracht (s. Fig. 13). Die dielektrische Schicht 62 setzt sich zusammen aus einer ersten Schicht 621, die z. B .aus SiO₂ besteht. Auf der ersten Schicht 621 ist eine zweite Schicht 622 angeordnet, die z. B. aus Si₃N₄ oder aus Al₂O₃ besteht. An der Oberfläche der zweiten Schicht 622 ist eine dritte Schicht 623 angeordnet, die z. B. aus SiO₂ besteht. Die dielektrische Schicht 62 weist insgesamt eine Dicke von etwa 10 nm auf. Davon entfallen z. B. 3 nm auf die erste Schicht 621, 3 nm auf die zweite Schicht 622 und 4 nm auf die dritte Schicht 623. An der Grenzfläche zwischen der ersten Schicht 621 und der zweiten Schicht 622 sind durch Dotierung mit Wolfram mit einer Dotierstoffkonzentration von z. B. 10¹⁴ bis 5 x 10¹⁵ cm⁻² Ladungsträgertraps angeordnet.

Auf die Oberfläche der dielektrischen Schicht 62 wird eine Spitze 64 eines Atomic Force oder Scanning Tunneling Mikroskops gerichtet, die mit einer positiven Spannung verbunden wird (s. Fig. 14). Die Halbleiterschicht 61 wird mit Erdpotential verbunden. Dadurch entsteht ein elektrisches Feld 65, in dem die Traps an der Grenzfläche zwischen der ersten Schicht 621 und der zweiten Schicht 622 durch Feldemission aus der Spitze 64 mit Elektronen beladen werden. Dadurch wird ein Bereich 66 mit negativen Ladungsträgern an der Grenzfläche zwischen der ersten Schicht 621 und der zweiten Schicht 622 gebildet (s. Fig. 15). Die negativen Ladungsträger sind durch die Traps fest in der dielektrischen Schicht 62 lokalisiert. Der Aufbau der dielektrischen Schicht 62 in dieser Ausführungsform ist vergleichbar mit den in nicht flüchtigen Speichern verwendeten dielektrischen Schichten. Die räumliche Ausdehnung des Bereiches 66 mit den fest lokalisierten negativen Ladungsträgern parallel zur Oberfläche der Halbleiterschicht 61 kann auf diese Weise im Bereich von 10 nm eingestellt werden. Es wird in diesem Bereich eine Ladungsdichte bis einige µC/cm², zum Beispiel 2µC/cm² erzielt.

Da Si₃N₄ und Al₂O₃ hohe Volumen- und Grenzflächentrapdichten aufweisen, die bis zu Werten von 10¹⁹ cm⁻² betragen, kann für Anwendungen, in denen eine Langzeitzuverlässigkeit nicht erforderlich ist, auf die Wolframdotierung verzichtet werden. Durch die Wolframdotierung wird die Schaltungsstruktur jedoch sehr zuverlässig, da dadurch Haltezeiten der Ladungsträger von einigen 100 Jahren erzielt werden. Die erste Schicht 621 sollte ausreichend dick sein, um eine Entladung der Traps durch direktes Tunneln in die Halbleiterschicht 61 zu unterdrücken.

Analog dem anhand von Fig. 13 bis 15 beschriebenen Verfahren können mit Löcher beladene Traps in einer dielektrischen Schicht aus z. B. SiO₂ durch lokale Feldemissionsinjektion (Fowler-Nordheim-Tunnel) von Löchern oder Elektronen aus der Halbleiterschicht erzeugt werden.

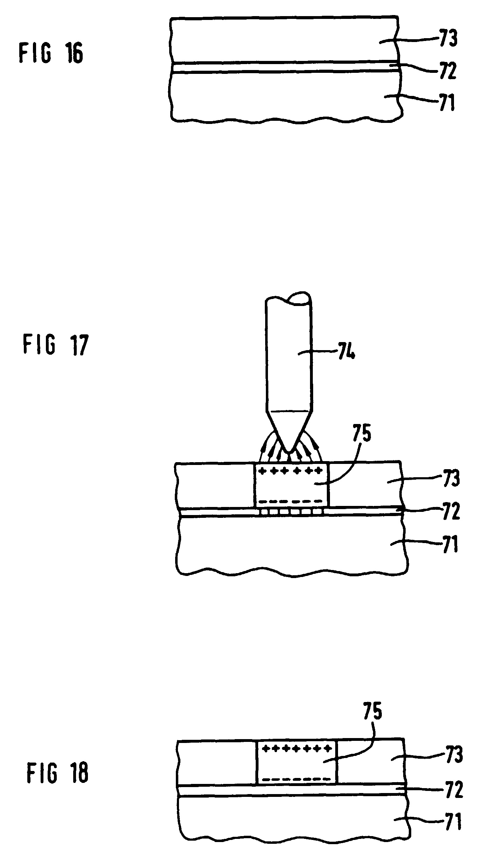

Auf eine Halbleiterschicht 71 aus z. B. monokristallinem Silizium wird eine SiO₂-Schicht 72, die z. B. 2 nm dick ist, aufgebracht (s. Fig. 16). Auf die SiO₂-Schicht 72 wird eine unpolarisierte ferroelektrische Schicht 73 aufgebracht. Die ferroelektrische Schicht wird z. B. BaTiO₃ , Pb (Zr, Ti) O₃ oder (Pb, La) (Zr, Ti) O₃ hergestellt. Die ferroelektrische Schicht 73 weist eine Dicke von z. B. 8 nm auf.

Auf die Oberfläche der ferroelektrischen Schicht 73 wird eine Spitze 74 eines Atomic Force oder Scanning Tunneling Mikroskops gerichtet. Mit Hilfe der Spitze 74 wird eine lokale Polarisation der ferroelektrischen Schicht 73 vorgenommen. Dadurch kommt es in einem Bereich 75 der ferroelektrischen Schicht 74 zu einer Trennung der Polarisationsladungen. Bedingt durch die Richtung des Polarisationsfeldes werden negative Ladungen in der Nähe der Grenzfläche zur SiO₂-Schicht 72 angesammelt, während positive Polarisationsladungen zur Oberfläche der ferroelektrischen Schicht getrieben werden (s. Fig. 17).

Nach Entfernen der Spitze 74 bleibt in dem Bereich 75 eine permanente Polarisation erhalten. Die an der Grenzfläche zur SiO₂-Schicht 72 angeordneten negativen Polarisationsladungen bewirken in der Oberfläche der Halbleiterschicht 71 eine Verschiebung des lokalen Oberflächenpotentials. Zur Fertigstellung der Schaltungsstruktur kann die Oberfläche der ferroelektrischen Schicht mit einer Gateelektrode versehen werden. Durch die Polarisation werden Ladungsspeicherungsdichten von einigen 10 µC/cm² erzielt.

Bei der Auswahl des Ferroelektrikums für die ferroelektrische Schicht muß darauf geachtet werden, daß das verwendete Ferroelektrikum eine ausreichend hohe Polarisation, Koerzitivfeldstärke, Curietemperatur und geringe Relaxation und Leckströme aufweist.

In den Ausführungsbeispielen wurden Strukturen mit Abmessungen um 10 nm beschrieben. Die erfindungsgemäße Schaltungsstruktur und die beschriebenen Herstellungsverfahren lassen sich jedoch auch für größere Strukturen, z. B. mit Mikrometerabmessungen einsetzen.

Die Erzeugung der elektrischen Ladungsverteilung in der dielektrischen Schicht läßt sich auch durch Verwendung scharf begrenzter Elektronen- oder Ionenstrahlung und von Lithographie- oder Abscheidungsverfahren unter Einsatz von Elektronen-, Ionen- oder Photonenstrahlen ausführen.

Die Schaltungsstrukturen sind auch für andere Halbleiter/Isolatorkombinationen, für Heterostruktur-Quanten-Well-Kanäle oder für Strukturen ohne Gateelektrode einsetzbar.

## Patentansprüche

1. Mikroelektronische Schaltungsstruktur
mit mindestens einer Halbleiterschicht und einer dielektrischen Schicht,
- wobei die Halbleiterschicht und die dielelektrische Schicht einander benachbart angeordnet sind,
- wobei die dielektrische Schicht eine nahe der Grenzfläche zur Halbleiterschicht lokalisierte elektrische Ladungsverteilung mit lokalisierten elektrischen Ladungen aufweist, die in der Halbleiterschicht eine Verschiebung des lokalen Halbleiteroberflächenpotentials bewirkt, und somit and der Oberfläche der Halbleiterschicht lokale Potentialbarrieren und dadurch Elektronen- bzw. Löcherkanäle bewirkt,
- wobei Form und Ausdehnung dieser Elektronen- bzw. Löcherkanäle durch die Ladungsverteilung in der dielektrischen Schicht vorgegeben wird.

2. Mikroelektronische Schaltungsstruktur nach Anspruch 1,
bei der in der Ladungsverteilung eine maximale Ladungsspeicherungsdichte dem Betrag nach von 1 bis 100 µC/cm² auftritt.

3. Mikroelektronische Schaltungsstruktur nach Anspruch 1 oder 2,
bei der die Halbleiterschicht dotiert ist.

4. Mikroelektronische Schaltungsstruktur nach einem der Ansprüche 1 bis 3,
bei der die Ladungsverteilung in der Ebene parallel zur Grenzfläche zur Halbleiterschicht inhomogen ist, so daß die Verschiebung des lokalen Halbleiteroberflächenpotentials in einem begrenzten Gebiet der Oberfläche der Halbleiterschicht bewirkt wird.

5. Mikroelektronische Schaltungsstruktur nach einem der Ansprüche 1 bis 4,
bei der auf der Oberfläche der dielektrischen Schicht mindestens eine Gateelektrode angeordnet ist, über die die Verschiebung des lokalen Halbleiteroberflächenpotentials in der Halbleiterschicht steuerbar ist.

6. Mikroelektronische Schaltungsstruktur nach einem der Ansprüche 1 bis 5,
bei der die dielektrische Schicht ein Ferroelektrikum umfaßt und bei der die Ladungsverteilung durch eine Polarisation des Ferroelektrikums realisiert ist.

7. Mikroelektronische Schaltungsstruktur nach Anspruch 6,
bei der die dielektrische Schicht mindestens eine amorphe oder polykristalline Schicht aus BaTiO₃, Pb (Zr, Ti) O₃ oder ((Pb, La)(Zr, Ti)O₃) umfaßt.

8. Mikroelektronische Schaltungsstruktur nach einem der Ansprüche 1 bis 5,
bei der die Ladungsverteilung negative und/oder positive elektrische Ladungsträger umfaßt.

9. Mikroelektronische Schaltungsstruktur nach Anspruch 8,
- bei der die dielektrische Schicht eine Schichtenfolge mit drei Schichten umfaßt, wobei eine erste Schicht der Halbleiterschicht unmittelbar benachbart angeordnet ist und der ersten Schicht eine zweite Schicht und der zweiten Schicht eine dritte Schicht unmittelbar benachbart angeordnet ist,
- bei der die zweite Schicht einen höheren Einfangquerschnitt für Ladungsträger aufweist als die erste Schicht und die dritte Schicht,
- bei der die erste Schicht und die dritte Schicht eine Potentialbarriere gegen Ladungsträgerabfluß aus der zweiten Schicht bilden,
- bei der die Dicke der ersten Schicht so eingestellt ist, daß die Ladungsverteilung von in der zweiten Schicht eingefangenen Ladungsträgern die Verschiebung des lokalen Halbleiteroberflächenpotentials in der Halbleiterschicht bewirkt.

10. Mikroelektronische Schaltungsstruktur nach Anspruch 9,
bei der die erste Schicht und die dritte Schicht SiO₂ umfassen und bei dem die zweite Schicht Si₃N₄ oder Al₂O₃ umfaßt.

11. Mikroelektronische Schaltungsstruktur nach Anspruch 10,
bei der die erste Schicht eine Dicke im Bereich zwischen 3 und 10 nm, die zweite Schicht eine Dicke im Bereich zwischen 3 und 10 nm und die dritte Schicht eine Dicke im Bereich zwischen 3 und 10 nm aufweisen.

12. Mikroelektronische Schaltungsstruktur nach einem der Ansprüche 8 bis 11,
bei der in der dielektrischen Schicht zur Bildung der Ladungsverteilung mit Ladungsträgern besetzte Störstellen mit einem gegenüber dem übrigen Teil der dielektrischen Schicht erhöhten Einfangquerschnitt für Ladungsträger angeordnet sind.

13. Mikroelektronische Schaltungsstruktur nach Anspruch 12,
bei der die Störstellen durch eine Dotierung mit Wolfram realisiert sind.

14. Mikroelektronische Schaltungsstruktur nach einem der Ansprüche 1 bis 13,
bei der die Halbleiterschicht aus monokristallinem Silizium besteht.

15. Mikroelektronische Schaltungsstruktur nach Anspruch 14,
bei der die Halbleiterschicht Teil eines SOI-Substrates ist.

16. Verfahren zur Herstellung einer mikroelektronischen Schaltungsstruktur,
- bei dem auf die Oberfläche einer Halbleiterschicht eine dielektrische Schicht aufgebracht wird,
- bei dem in der dielektrischen Schicht nahe der Grenzfläche zur Halbleiterschicht eine Ladungsverteilung mit lokalisierten elektrischen Ladungen erzeugt wird, die in der Halbleiterschicht eine Verschiebung des lokalen Halbleiteroberflächenpotentials bewirkt, und somit and der Oberfläche der Halbleiterschicht lokale Potentialbarrieren und dadurch Elektronen- bzw. Löcherkanäle bewirkt, wobei
- Form und Ausdehnung dieser Elektronen- bzw. Löcherkanäle durch die Ladungsverteilung in der dielektrischen Schicht vorgegeben wird.

17. Verfahren nach Anspruch 16,
bei dem die Ladungsverteilung in der dielektrischen Schicht in der Ebene parallel zur Grenzfläche zur Halbleiterschicht inhomogen ist, so daß die Verschiebung des lokalen Halbleiteroberflächenpotentials in einem begrenzten Gebiet der Oberfläche der Halbleiterschicht bewirkt wird.

18. Verfahren nach Anspruch 16 oder 17,
bei dem die Ladungsverteilung mit maximalen Ladungsspeicherungsdichten dem Betrag nach von 1 bis 100 µC/cm² erzeugt wird.

19. Verfahren nach einem der Ansprüche 16 bis 18,
bei dem auf der Oberfläche der dielektrischen Schicht eine Gateelektrode aufgebracht wird, über die die Verschiebung des lokalen Halbleiteroberflächenpotentials in der Halbleiterschicht steuerbar ist.

20. Verfahren nach einem der Ansprüche 16 bis 19,
- bei dem zur Erzeugung der Ladungsverteilung die Oberfläche der dielektrischen Schicht mit einer ein Metall enthaltenden Substanz belegt wird,
- bei dem positive Metallionen durch Anlegen eines lokalen elektrischen Feldes in die dielektrische Schicht eingetrieben werden.

21. Verfahren nach Anspruch 20,
bei dem die das Metall enthaltende Substanz lokal abgeschieden wird.

22. Verfahren nach einem der Ansprüche 16 bis 19,
- bei dem positive Metallionen ganzflächig in die dielektrische Schicht bis an die Grenzfläche zur Halbleiterschicht eingebracht werden,
- bei dem durch Anlegen eines lokalen elektrischen Feldes lokal positive Ladungsträger an der Grenzfläche zur Halbleiterschicht entfernt werden.

23. Verfahren nach einem der Ansprüche 20 bis 22,
bei dem das lokale elektrische Feld dadurch erzeugt wird, daß zwischen einer Metallspitze, die auf die Oberfläche der dielektrischen Schicht an einem Ort, an dem Metallionen eingetrieben werden sollen, gerichtet ist, und der Halbleiterschicht eine elektrische Spannung angelegt wird.

24. Verfahren nach Anspruch 23,
bei dem die Metallspitze einen Radius zwischen 1 nm und 20 nm aufweist und bei dem die Metallspitze in einem Abstand zwischen 0 nm und 10 nm von der Oberfläche der dielektrischen Schicht angeordnet ist und bei dem der Betrag der elektrischen Spannung zwischen 10⁵V/cm und 10⁷ V/cm liegt.

25. Verfahren nach einem der Ansprüche 20 bis 24,
bei dem die Metallionen bei einer höheren Temperatur als der Betriebstemperatur der Schaltungsstruktur eingetrieben werden.

26. Verfahren nach einem der Ansprüche 20 bis 25,
bei dem als Metall Kalium, Rubidium oder Cäsium verwendet wird.

27. Verfahren nach einem der Ansprüche 16 bis 19,
bei dem die Ladungsverteilung unter Verwendung von lokalisierter Elektronen-Ionen- oder Photonenstrahlung erzeugt wird.

28. Verfahren nach einem der Ansprüche 16 bis 19,
bei dem die Ladungsverteilung durch maskierte Ionenimplantation erzeugt wird.

29. Verfahren nach einem der Ansprüche 16 bis 19,
bei dem in der dielektrischen Schicht Ladungsträgertraps gebildet werden, die durch Ladungsträgerinjektion beladen werden.

30. Verfahren nach Anspruch 29,
bei dem die dielektrische Schicht aus drei benachbarten Schichten gebildet wird, wobei die mittlere Schicht einen höheren Einfangquerschnitt für Ladungsträger aufweist als die beiden äußeren Schichten und die beiden äußeren Schichten eine Barriere gegen den Ladungsträgerabfluß aus der mittleren Schicht bilden.

31. Verfahren nach Anspruch 30,
bei dem die äußeren Schichten aus SiO₂ und die mittlere Schicht aus Si₃N₄ oder Al₂O₃ gebildet werden, bei dem die äußeren Schichten und die mittlere Schicht in Dicken von jeweils höchstens 10 nm gebildet werden und bei dem die an die Halbleiterschicht angrenzende äußere Schicht in einer Dicke von mindestens 3 nm gebildet wird.

32. Verfahren nach einem der Ansprüche 29 bis 31,
bei dem die Ladungsträgertraps durch Dotierung gebildet werden.

33. Verfahren nach Anspruch 32,
bei dem die Ladungsträgertraps durch Implantation von Wolfram gebildet werden.

34. Verfahren nach einem der Ansprüche 16 bis 19,
- bei dem zur Herstellung der dielektrischen Schicht mindestens eine ferroelektrische Schicht erzeugt wird,
- bei dem die ferroelektrische Schicht lokal polarisiert wird.

35. Verfahren nach Anspruch 34,
bei dem die ferroelektrische Schicht mit einer auf die Oberfläche der dielektrischen Schicht gerichteten Metallspitze polarisiert wird.

36. Verfahren nach Anspruch 34 oder 35,
bei dem die ferroelektrische Schicht aus amorphem oder polykristallinem BaTiO₃, Pb(Zr, Ti)O₃ oder ((Pb, La) (Zr, Ti)O₃ gebildet wird.

37. Verfahren nach einem der Ansprüche 16 bis 36,
bei dem die Halbleiterschicht aus monokristallinem Silizium gebildet wird.

38. Verfahren nach Anspruch 37,
bei dem die Halbleiterschicht Teil eines SOI-Substrates ist.

## Revendications

1. Structure de circuit microélectronique comportant au moins une couche semi-conductrice, et une couche diélectrique,
- la couche semi-conductrice et la couche diélectrique étant disposées de manière adjacente l'une à l'autre,
- la couche diélectrique présentant une distribution de la charge électrique localisée avec des charges électriques localisées à proximité de l'interface avec la couche semi-conductrice, qui entraîne un déplacement du potentiel de surface du semi-conducteur local dans la couche semi-conductrice et crée ainsi à la surface de la couche semi-conductrice des barrières de potentiel locales et par la même des canaux électroniques ou à trous,
- la forme et l'extension de ces canaux électroniques ou à trous étant prédéfinies par la distribution de la charge dans la couche diélectrique.

2. Structure de circuit microélectronique selon la revendication 1, dans laquelle apparaît dans la distribution de charge une densité d'accumulation de charge maximale d'une valeur absolue de 1 à 100 µC/cm^{2.}

3. Structure de circuit microélectronique selon la revendication 1 ou la revendication 2, dans laquelle la couche semi-conductrice est dopée.

4. Structure de circuit microélectronique selon l'une des revendications 1 à 3, dans laquelle la distribution de charge est non homogène sur le plan parallèle à l'interface avec la couche semi-conductrice, si bien qu'elle entraîne le déplacement du potentiel de surface du semi-conducteur local dans une zone limitée de la surface de la couche semi-conductrice.

5. Structure de circuit microélectronique selon l'une des revendications 1 à 4, dans laquelle au moins une grille est disposée à la surface de la couche diélectrique, par l'intermédiaire de laquelle le déplacement du potentiel de surface du semi-conducteur local peut être dirigé dans la couche semi-conductrice.

6. Structure de circuit microélectronique selon l'une des revendications 1 à 5, dans laquelle la couche diélectrique comprend un ferroélectrique et dans laquelle la distribution de charge est réalisée par une polarisation du ferroélectrique.

7. Structure de circuit microélectronique selon la revendication 6, dans laquelle la couche diélectrique comprend au moins une couche amorphe ou polycristalline en BaTiO₃, Pb (Zr, Ti) 03 ou ((Pb, La) (Zr, Ti) O₃₎.

8. Structure de circuit microélectronique selon l'une des revendications 1 à 5, dans laquelle la distribution de charge comprend des porteurs de charge électriques négatifs et/ou positifs.

9. Structure de circuit microélectronique selon la revendication 8,
- dans laquelle la couche diélectrique comprend une suite de couches de trois couches, une première couche étant disposée de manière directement adjacente à la couche semi-conductrice, une seconde et une troisième couche étant disposées de manière directement adjacente à la première et à la seconde couche respectivement,
- dans laquelle la seconde couche présente une section efficace de capture pour porteurs de charge supérieure à la première et à la troisième couche,
- dans laquelle la première couche et la troisième couche forment une barrière de potentiel contre l'écoulement de porteurs de charge de la seconde couche,
- dans laquelle l'épaisseur de la première couche est ajustée de telle manière que la distribution de charge des porteurs de charge piégés dans la seconde couche entraîne le déplacement du potentiel de surface du semi-conducteur local dans la couche semi-conductrice.

10. Structure de circuit microélectronique selon la revendication 9, dans laquelle la première couche et la troisième couche comprennent du SiO₂ et dans laquelle la seconde couche comprend du Si₃N₄ ou du Al₂O₃.

11. Structure de circuit microélectronique selon la revendication 10, dans laquelle la première couche a une épaisseur comprise dans une plage de 3 à 10 nm, la seconde couche une épaisseur comprise dans une plage de 3 à 10 nm et la troisième couche une épaisseur comprise dans une plage de 3 et 10 nm.

12. Structure de circuit microélectronique selon l'une des revendications 8 à 11, dans laquelle sont disposées dans la couche diélectrique pour la formation de la distribution de charge des impuretés occupées par des porteurs de charges, présentant une section efficace de capture pour porteurs de charge plus grande par rapport à la partie restante de la couche diélectrique.

13. Structure de circuit microélectronique selon la revendication 12, dans laquelle les impuretés sont réalisées par un dopage au tungstène.

14. Structure de circuit microélectronique selon l'une des revendications 1 à 13, dans laquelle la couche semi-conductrice est composée de silicium monocristallin.

15. Structure de circuit microélectronique selon la revendication 14, dans laquelle la couche semi-conductrice fait partie d'un substrat SOI.

16. Procédé de fabrication d'une structure de circuit microélectronique,
- dans lequel une couche diélectrique est déposée sur une couche semi-conductrice,
- dans lequel est produite dans la couche diélectrique à proximité de l'interface avec la couche semi-conductrice une distribution de charge avec des charges électriques localisées qui entraînent dans la couche semi-conductrice un déplacement du potentiel de surface du semi-conducteur local, et crée ainsi à la surface de la couche semi-conductrice des barrières de potentiel locales et ainsi des canaux électroniques ou à trous, la forme et l'extension de ces canaux électroniques ou à trous étant prédéfinies par la répartition de charge dans la couche diélectrique.

17. Procédé selon la revendication 16, dans lequel la distribution de charge dans la couche diélectrique dans le plan parallèle à l'interface avec la couche semi-conductrice est non-homogène si bien qu'elle entraîne le déplacement du potentiel de surface du semi-conducteur local dans une zone limitée de la surface de la couche semi-conductrice.

18. Procédé selon les revendications 16 ou 17, dans lequel la distribution de la charge est produite avec des densités d'accumulation de charge maximales d'une valeur absolue de 1 à 100 µC/cm².

19. Procédé selon l'une des revendications 16 à 18, dans lequel est déposée à la surface de la couche diélectrique une grille par l'intermédiaire de laquelle il est possible de diriger le déplacement du potentiel de surface du semi-conducteur local dans la couche semi-conductrice.

20. Procédé selon l'une des revendications 16 à 19,
- dans lequel la surface de la couche diélectrique est recouverte d'une substance contenant un métal pour la production de la distribution de charge,
- dans lequel on fait pénétrer des ions métalliques positifs en appliquant un champ électrique local dans la couche diélectrique.

21. Procédé selon la revendication 20,
dans lequel la substance contenant le métal est déposée localement.

22. Procédé selon l'une des revendications 16 à 19,
- dans lequel des ions métalliques positifs sont déposés sur toute la surface dans la couche diélectrique jusqu'à l'interface avec la couche semi-conductrice,
- dans lequel des porteurs de charge positifs sont éliminés localement à l'interface avec la couche semi-conductrice en appliquant un champ électrique local.

23. Procédé selon l'une des revendications 20 à 22, dans lequel le champ électrique local est créé en appliquant une tension électrique entre une pointe métallique dirigée sur la surface de la couche diélectrique à un endroit où l'on doit faire pénétrer des ions métalliques, et la couche semi-conductrice.

24. Procédé selon la revendication 23,
dans lequel la pointe métallique a un rayon compris entre 1 nm et 20 nm et dans lequel la pointe métallique est disposée à une distance comprise entre 0 nm et 10 nm de la surface de la couche diélectrique et dans lequel la valeur absolue de la tension électrique est comprise entre 10⁵ V/cm et 10⁷ V/cm.

25. Procédé selon l'une des revendications 20 à 24,
dans lequel on fait pénétrer des ions métalliques à une température supérieure à la température de service de la structure du circuit.

26. Procédé selon l'une des revendications 20 à 25,
dans lequel on utilise comme métal du potassium, du rubidium ou du césium.

27. Procédé selon l'une des revendications 16 à 19,
dans lequel la distribution de charge est produite en utilisant un faisceau d'électrons, d'ions ou de photons localisé.

28. Procédé selon l'une des revendications 16 à 19,
dans lequel la distribution de charge est produite par implantation masquée d'ions.

29. Procédé selon l'une des revendications 16 à 19,
dans lequel des pièges à porteurs de charge sont formés dans la couche diélectrique, qui sont chargés par injection de porteurs de charge.

30. Procédé selon la revendication 29,
dans lequel la couche diélectrique est formée de trois couches voisines, la couche intermédiaire présentant une section efficace de capture pour porteurs de charge supérieure aux deux couches extérieures et les deux couches extérieures formant une barrière contre l'écoulement des porteurs de charge de la couche intermédiaire.

31. Procédé selon la revendication 30,
dans lequel les couches extérieures sont formées en SiO₂ et la couche intermédiaire en Si₃N₄ ou Al₂O₃, dans lequel les couches extérieures et la couche intermédiaire sont formées dans les épaisseurs de 10 nm au maximum respectivement, et dans lequel la couche extérieure adjacente à la couche semi-conductrice est formée à une épaisseur d'au moins 3 nm.

32. Procédé selon l'une des revendications 29 à 31,
dans lequel les pièges à porteurs de charge sont formés par dopage.

33. Procédé selon la revendication 32,
dans lequel les pièges à porteurs de charge sont formés par implantation de tungstène.

34. Procédé selon l'une des revendications 16 à 19,
- dans lequel au moins une couche ferroélectrique est créée pour la production de la couche diélectrique,
- dans lequel la couche ferroélectrique est polarisée localement.

35. Procédé selon la revendication 34,
dans lequel la couche ferroélectrique est polarisée avec une pointe métallique dirigée sur la surface de la couche diélectrique.

36. Procédé selon les revendications 34 ou 35,
dans lequel la couche ferroélectrique est formée de BaTiO₃, Pb (Zr, Ti) 03 ((Pb, La) (Zr, Ti) 03 ou amorphes ou polycristallins.

37. Procédé selon l'une des revendications 16 à 36,
dans lequel la couche semi-conductrice est formée de silicium monocristallin.

38. Procédé selon la revendication 37,
dans lequel la couche semi-conductrice fait partie d'un substrat SOI.

## Claims

1. Microelectronic circuit structure having at least one semiconductor layer and one dielectric layer,
- the semiconductor layer and the dielectric layer being arranged adjacent to one another,
- the dielectric layer having an electric charge distribution with localized electric charges which is localized near to the interface with the semiconductor layer and effects in the semiconductor layer a shift in the local semiconductor surface potential, and consequently effects at the surface of the semiconductor layer local potential barriers and, as a result, electron and hole channels,
- the form and extent of these electron and hole channels being predetermined by the charge distribution in the dielectric layer.

2. Microelectronic circuit structure according to Claim 1,
in which a maximum charge storage density of the order of 1 to 100 µC/cm² occurs in the charge distribution.

3. Microelectronic circuit structure according to Claim 1 or 2,
in which the semiconductor layer is doped.

4. Microelectronic circuit structure according to one of Claims 1 to 3,
in which the charge distribution is inhomogeneous in the plane parallel to the interface with the semiconductor layer, with the result that the shift in the local semiconductor surface potential is effected in a limited region of the surface of the semiconductor layer.

5. Microelectronic circuit structure according to one of Claims 1 to 4,
in which at least one gate electrode is arranged on the surface of the dielectric layer, via which gate electrode the shift in the local semiconductor surface potential in the semiconductor layer can be controlled.

6. Microelectronic circuit structure according to one of Claims 1 to 5,
in which the dielectric layer comprises a ferroelectric and in which the charge distribution is realized by polarization of the ferroelectric.

7. Microelectronic circuit structure according to Claim 6,
in which the dielectric layer comprises at least one amorphous or polycrystalline layer made of BaTiO₃, Pb(Zr, Ti)O₃ or ((Pb, La) (Zr, Ti)O₃).

8. Microelectronic circuit structure according to one of Claims 1 to 5,
in which the charge distribution comprises negative and/or positive electric charge carriers.

9. Microelectronic circuit structure according to Claim 8,
- in which the dielectric layer comprises a layer sequence having three layers, a first layer being arranged directly adjacent to the semiconductor layer and a second layer being arranged directly adjacent to the first layer and a third layer being arranged directly adjacent to the second layer,
- in which the second layer has a higher capture cross-section for charge carriers than the first layer and the third layer,
- in which the first layer and the third layer form a potential barrier against the flowing-away of charge carriers from the second layer,
- in which the thickness of the first layer is set in such a way that the charge distribution of charge carriers captured in the second layer effects the shift in the local semiconductor surface potential in the semiconductor layer.

10. Microelectronic circuit structure according to Claim 9,
in which the first layer and the third layer comprise SiO₂ and in which the second layer comprises Si₃N₄ or Al₂O₃.

11. Microelectronic circuit structure according to Claim 10,
in which the first layer has a thickness in the range between 3 and 10 nm, the second layer has a thickness in the range between 3 and 10 nm and the third layer has a thickness in the range between 3 and 10 nm.

12. Microelectronic circuit structure according to one of Claims 8 to 11,
in which impurities are arranged in the dielectric layer for the purpose of forming the charge distribution, which impurities are occupied by charge carriers and have an increased capture cross-section for charge carriers compared with the remaining part of the dielectric layer.

13. Microelectronic circuit structure according to Claim 12,
in which the impurities are realized by doping with tungsten.

14. Microelectronic circuit structure according to one of Claims 1 to 13,
in which the semiconductor layer is composed of monocrystalline silicon.

15. Microelectronic circuit structure according to Claim 14,
in which the semiconductor layer is part of an SOI substrate.

16. Method for producing a microelectronic circuit structure,
- in which a dielectric layer is applied to the surface of a semiconductor layer,
- in which a charge distribution with localized electric charges is produced in the dielectric layer near to the interface with the semiconductor layer, which charge distribution effects in the semiconductor layer a shift in the local semiconductor surface potential, and consequently effects at the surface of the semiconductor layer local potential barriers and, as a result, electron and hole channels,
- the form and extent of these electron and hole channels being predetermined by the charge distribution in the dielectric layer.

17. Method according to Claim 16,
in which the charge distribution in the dielectric layer is inhomogeneous in the plane parallel to the interface with the semiconductor layer, with the result that the shift in the local semiconductor surface potential is effected in a limited region of the surface of the semiconductor layer.

18. Method according to Claim 16 or 17,
in which the charge distribution is produced with maximum charge storage densities of the order of 1 to 100 µC/cm².

19. Method according to one of Claims 16 to 18,
in which a gate electrode is applied to the surface of the dielectric layer, via which gate electrode the shift in the local semiconductor surface potential in the semiconductor layer can be controlled.

20. Method according to one of Claims 16 to 19,
- in which the surface of the dielectric layer is covered with a substance containing a metal for the purpose of producing the charge distribution,
- in which positive metal ions are driven into the dielectric layer by applying a local electric field.

21. Method according to Claim 20,
in which the substance containing the metal is locally deposited.

22. Method according to one of Claims 16 to 19,
- in which positive metal ions are introduced into the dielectric layer over the whole area up to the interface with the semiconductor layer,
- in which locally positive charge carriers are removed at the interface with the semiconductor layer by applying a local electric field.

23. Method according to one of Claims 20 to 22,
in which the local electric field is produced by applying an electric voltage between a metal tip, which is directed at the surface of the dielectric layer at a location where metal ions are to be driven in, and the semiconductor layer.

24. Method according to Claim 23,
in which the metal tip has a radius of between 1 nm and 20 nm and in which the metal tip is arranged at a distance of between 0 nm and 10 nm from the surface of the dielectric layer and in which the magnitude of the electric voltage is between 10⁵ V/cm and 10⁷ V/cm.

25. Method according to one of Claims 20 to 24,
in which the metal ions are driven in at a higher temperature than the operating temperature of the circuit structure.

26. Method according to one of Claims 20 to 25,
in which the metal used is potassium, rubidium or caesium.

27. Method according to one of Claims 16 to 19,
in which the charge distribution is produced using localized electron, ion or photon radiation.

28. Method according to one of Claims 16 to 19,
in which the charge distribution is produced by masked ion implantation.

29. Method according to one of Claims 16 to 19,
in which charge carrier traps which are loaded by charge carrier injection are formed in the dielectric layer.

30. Method according to Claim 29,
in which the dielectric layer is formed from three adjacent layers, the middle layer having a higher capture cross-section for charge carriers than the two outer layers and the two outer layers forming a barrier against the flowing-away of charge carriers from the middle layer.

31. Method according to Claim 30,
in which the outer layers are formed from SiO₂ and the middle layer is formed from Si₃N₄ or Al₂O₃, in which the outer layers and the middle layer are formed with thicknesses of in each case at most 10 nm and in which the outer layer adjoining the semiconductor layer is formed with a thickness of at least 3 nm.

32. Method according to one of Claims 29 to 31,
in which the charge carrier traps are formed by doping.

33. Method according to Claim 32,
in which the charge carrier traps are formed by the implantation of tungsten.

34. Method according to one of Claims 16 to 19,
- in which at least one ferroelectric layer is produced for the purpose of producing the dielectric layer,
- in which the ferroelectric layer is locally polarized.

35. Method according to Claim 34,
in which the ferroelectric layer is polarized with a metal tip directed at the surface of the dielectric layer.

36. Method according to Claim 34 or 35,
in which the ferroelectric layer is formed from amorphous or polycrystalline BaTiO₃, Pb(Zr, Ti)O₃ or ((Pb, La) (Zr, Ti)O₃).

37. Method according to one of Claims 16 to 36,
in which the semiconductor layer is formed from monocrystalline silicon.

38. Method according to Claim 37,
in which the semiconductor layer is part of an SOI substrate.
